# EUROPÄISCHE PATENTSCHRIFT

(11) **EP 1 174 014 B1**
(45) Veröffentlichungstag und Bekanntmachung des Hinweises auf die Patenterteilung: **06.10.2004**
(21) Anmeldenummer: 00934854.1
(22) Anmeldetag: 03.04.2000
(51) Int. Cl.: H05K 13/08

(54) **VERFAHREN ZUM BETRIEB EINES BESTÜCKAUTOMATEN, BESTÜCKAUTOMAT, AUSWECHSELBARE KOMPONENTE FÜR EINEN BESTÜCKAUTOMATEN UND SYSTEM AUS EINEM BESTÜCKAUTOMATEN UND EINER AUSWECHSELBAREN KOMPONENTE**
METHOD FOR OPERATING A PICK-AND-PLACE DEVICE, PICK-AND-PLACE DEVICE, EXCHANGEABLE COMPONENT FOR A PICK-AND-PLACE DEVICE AND SYSTEM THAT CONSISTS OF A PICK-AND-PLACE DEVICE AND AN EXCHANGEABLE COMPONENT
PROCEDE POUR FAIRE FONCTIONNER UN DISPOSITIF AUTOMATIQUE DE MISE EN PLACE DE COMPOSANTS, DISPOSITIF AUTOMATIQUE DE MISE EN PLACE DE COMPOSANTS, ELEMENT INTERCHANGEABLE POUR UN TEL DISPOSITIF, ET SYSTEME CONSTITUE D'UN TEL DISPOSITIF ET D'UN ELEMENT INTERCHANGEABLE

(30) Priorität: 30.04.1999 DE 19919924
(43) Veröffentlichungstag der Anmeldung: 23.01.2002
(73) Patentinhaber: SIEMENS AKTIENGESELLSCHAFT, 80333 München (DE)
(72) Erfinder: HUBER, Wolfgang, D-81379 München (DE); MEHDIANPOUR, Mohammad, D-81829 München (DE)
(86) Internationale Anmeldenummer: PCT/DE2000/001012
(87) Internationale Veröffentlichungsnummer: WO 2000/067544

(56) Entgegenhaltungen:
- EP-A- 0 582 171
- US-A- 5 255 429
- US-A- 5 400 497
- US-A- 5 537 204
- US-A- 5 741 114

## Beschreibung

Die Erfindung bezieht sich auf ein Verfahren zum Betrieb eines Bestückautomaten, einen Bestückautomaten, eine auswechselbare Komponente für einen Bestückautomaten sowie ein System aus einem Bestückautomaten und einer auswechselbaren Komponente des Bestückautomaten.

In Bestückautomaten werden Bauelemente mittels eines Bestückkopfes aus Zuführeinheiten entnommen und in vorgegebenen Positionen auf Substrate aufgesetzt. Damit die Bauelemente lagerichtig auf das Substrat aufgesetzt werden, wird die Position der Bauelemente am Bestückkopf mit Hilfe von Sensoren ermittelt. Eine Steuereinrichtung des Bestückautomaten steuert dann in Abhängigkeit von der ermittelten Lage der Bauelemente den Bestückkopf parallel zur Ebene des Substrates so, daß das Aufsetzen in der korrekten Lage erfolgt. Für eine möglichst hohe Flexibilität bei der Bestückung von unterschiedlichen Bauelementen auf unterschiedlichste Substrate ist ein Teil der Komponenten eines Bestückautomaten auswechselbar ausgebildet. So existieren beispielsweise Bestückköpfe, die mehrere Bauelemente aufnehmen können, und dann die aufgenommenen Bauelemente hintereinander auf die vorgegebenen Positionen auf dem Substrat absetzen, ohne zwischendurch erst wieder zu den Zuführeinheiten verfahren zu müssen. Dadurch ergibt sich eine hohe Bestückleistung, d.h. eine möglichst hohe Anzahl bestückter Bauelemente pro Zeiteinheit. Darüber hinaus sind Bestückköpfe bekannt, die nur ein Bauelement aufnehmen, dieses aber hochgenau auf das Substrat absetzen. Außerdem sind für unterschiedlich große Bauelemente auch unterschiedlich große Bestückköpfe vorgesehen, so daß je nach Bestückprozeß unterschiedliche Bestückköpfe zum Einsatz kommen.

Je nach Art der zu bestückenden Bauelemente werden auch unterschiedliche Zuführeinheiten eingesetzt, außerdem werden beispielsweise unterschiedliche Sensoren für die Positionserkennung der Substrate verwendet.

Nach einem Wechsel der Komponenten ist die eindeutige Lagezuordnung der Komponenten und des Bestückautomaten zueinander nicht mehr gewährleistet. Daher wird nach dem Einbau auswechselbarer Komponenten der Bestückautomat neu kalibriert. Dafür ist beispielsweise aus US 5 537 204 ein Verfahren bekannt, bei dem ein Glassubstrat mit Markierungen anstelle des zu bestückenden Substrates benutzt wird, und Glasplättchen anstelle der Bauelemente auf dem Glassubstrat positioniert werden. Die Position der Glassubstrate auf dem Glassubstrat wird anschließend optisch vermessen. Die gemessenen Abweichungen der Positionen der Glassubstrate im Vergleich zu den Sollpositionen werden dann in die Steuereinrichtung des Bestückautomaten eingegeben, damit die Steuereinrichtung im späteren Bestückprozeß diese Abweichungen berücksichtigt. Eine solche Kalibrierung ist allerdings sehr zeitaufwendig, sie dauert ca. 1 bis 2 Stunden.

Es ist die Aufgabe der Erfindung, ein Verfahren zum Betrieb eines Bestückautomaten, einen Bestückautomaten, eine auswechselbare Komponente für einen Bestückautomaten und ein System aus einem Bestückautomaten und einer auswechselbaren Komponente des Bestückautomaten anzugeben, die einen schnelleren und einfacheren Wechsel der auswechselbaren Komponenten ermöglichen.

Die Aufgabe wird erfindungsgemäß gelöst durch ein Verfahren mit den Merkmalen des Anspruchs 1, durch einen Bestückautomaten mit den Merkmalen des Anspruchs 8, durch eine auswechselbare Komponente für einen Bestückautomaten mit den Merkmalen des Anspruchs 9 und durch ein System aus einem Bestückautomaten und einer auswechselbaren Komponente des Bestückautomaten gemäß Anspruch 14.

Dabei sind eine Speichereinrichtung in der auswechselbaren Komponente, sowie eine die Speichereinrichtung auslesende Steuereinrichtung des Bestückautomaten vorgesehen. In der Speichereinrichtung der auswechselbaren Komponente sind charakteristische Daten der auswechselbaren Komponente eingespeichert, die nach dem Einbau dieser Komponente von der Steuereinrichtung ausgelesen werden. Die ausgelesenen Daten werden dann von der Steuereinrichtung im nachfolgenden Bestückprozeß eingesetzt.

In vorteilhafter Weise werden gemäß Anspruch 2 die geometrischen Daten der auswechselbaren Komponente vor dem Einbau gemessen und als charakteristische Daten abgespeichert. Durch das Vermessen der Komponente vor dem Einbau entfällt der aufwendige Kalibrierungsprozeß nach dem Einbau. Denn die Steuereinrichtung erhält durch Kenntnis der geometrischen Daten unter Berücksichtigung eines festen Bezugspunkts bereits alle Daten, die für die spätere Lagekorrektur der Bauelemente am Bestückkopf von Bedeutung sind.

Für eine spätere Nachverfolgung ("retraceability") ist es gemäß Anspruch 3 in vorteilhafter Weise vorgesehen, daß unterschiedlichen auswechselbaren Komponenten unterschiedliche Identifizierungscodes zugeordnet werden und diese als charakteristische Daten abgespeichert und von der Steuereinrichtung ausgelesen werden. Dadurch kann bei einer Reihe von Fehlbestückungen von Substraten gegebenenfalls ein schadhafter Bestückkopf oder eine andere auswechselbare Komponente, die nicht mehr ordnungsgemäß funktioniert, erkannt werden.

In einer bevorzugten Ausgestaltung des Verfahrens nach Anspruch 4 ist vorgesehen, daß die einzelnen Komponenten zu sog. Komponentenklassen zusammengefaßt werden, deren kompletter Funktionsumfang in einer Funktionsliste zusammen mit der zu den jeweiligen einzelnen Funktionen gehörenden Ansteuerungen in der Steuereinrichtung des Bestückautomaten bereits abgespeichert sind. Wird nun in einer auswechselbaren Komponente in der dazugehörigen Speichereinrichtung hinterlegt, welche Funktionen dieser Funktionsliste diese auswechselbare Komponente aufweist, so ist der Steuereinrichtung des Bestückautomaten nach dem Auslesen bekannt, wie diese auswechselbare Komponente anzusteuern ist, ohne daß aufwendige Änderungen in der Steuersoftware zu erfolgen haben.

Der Datenaustausch kann dabei entweder über elektrische Leitungen gemäß Anspruch 5 oder drahtlos gemäß Anspruch 6 erfolgen. Der drahtlose Datenaustausch hat den Vorteil, daß keine aufwendigen zusätzlichen elektrischen Steckverbindungen erforderlich sind.

In der bevorzugten Ausgestaltung nach Anspruch 7 läßt sich für Bestückköpfe mit mehreren Saugpipetten, der Schlag, das ist der Unterschied der Positionen der Saugpipetten im eingefahrenen und im ausgefahrenen Zustand, herausrechnen.

Bei der bevorzugten Ausgestaltung der auswechselbaren Komponente gemäß Anspruch 10 ist die Speichereinrichtung als berührungslos beschreibbarer und auslesbarer Speicher ("Transponder, TAG") ausgebildet, der keine eigene Energieversorgung benötigt. Solche Speichereinrichtungen lassen sich problemlos in jede auswechselbare Komponente integrieren.

Die auswechselbare Komponente kann dabei entweder als Bestückkopf gemäß Anspruch 11, als Zuführeinheit gemäß Anspruch 12 oder als Sensor gemäß Anspruch 13 ausgebildet sein. Je nach Komponententyp sind dabei natürlich unterschiedliche Daten in der jeweils zugeordneten Speichereinrichtung hinterlegt, damit die Steuereinrichtung des Bestückautomaten die für sie jeweils relevanten Daten auslesen kann.

In den Figuren der Zeichnung wird anhand von Ausführungsbeispielen die Erfindung näher erläutert. Dabei zeigen
Figur 1 eine schematische Seitenansicht eines Bestückautomaten,
Figur 2 eine schematische Draufsicht auf einen Bestückautomaten,
Figur 3 eine schematische Seitenansicht einer Vermessung eines Bestückkopfes außerhalb des Bestückautomaten und
Figur 4 ein Struktogramm für das erfindungsgemäße Verfahren.

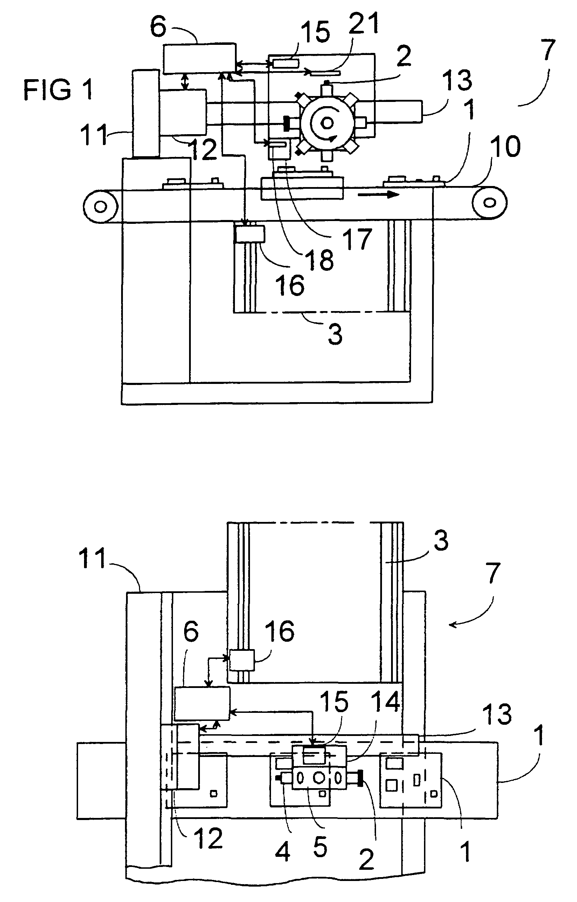

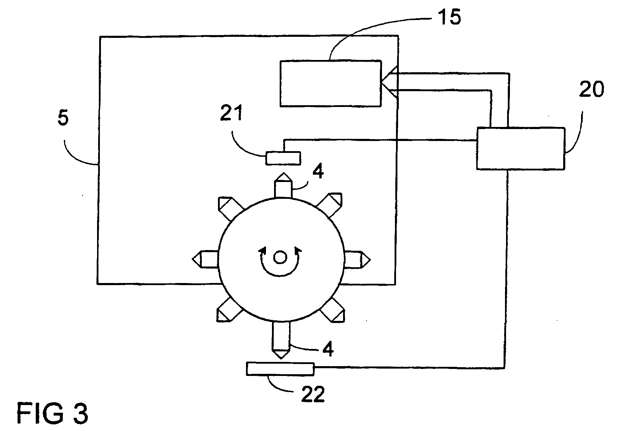

In Figur 1 ist eine schematische Seitenansicht eines Bestückautomaten 7 und in Figur 2 eine entsprechende schematische Draufsicht dargestellt. Im Bestückautomaten 7 werden Substrate 1 mit Bauelementen 2 bestückt, indem die in Zuführeinheiten 3 angelieferten Bauelemente 2 durch Saugpipetten 4 als Haltevorrichtungen eines Bestückkopfes 5 aufgenommen werden und anschließend in der vorgegebenen Position auf das Substrat 1 aufgesetzt werden. Der Bestückkopf 5 ist dabei im wesentlichen parallel zur Oberfläche des Substrats 1 beweglich. Dafür dient eine erste Schiene 11, an der ein erster Schlitten 12 beweglich befestigt ist. An diesem ersten Schlitten 12 ist im wesentlichen senkrecht zur ersten Schiene 11 eine zweite Schiene 13 befestigt, an der sich ein zweiter Schlitten 14 bewegt. Dieser zweite Schlitten 14 ist mit dem Bestückkopf 5 verbunden. Eine Steuereinrichtung 6 bewegt den ersten Schlitten 12 an den zweiten Schlitten 14 so, daß der Bestückkopf 5 zu den Zuführeinheiten 3 und nach dem Aufnehmen eines Bauelements 2 im wesentlichen parallel zur Oberfläche des Substrats 2 bewegt wird. Im Bestückkopf 5 ist eine Bauelemente-Kamera 21 vorgesehen, die ein Bild des an der Saugpipette 4 hängenden Bauelementes 2 aufnimmt und an die Steuereinrichtung 6 übermittelt. In der Steuereinrichtung 6 wird das Bild ausgewertet und in Abhängigkeit des ausgewerteten Bildes wird der Bestückkopf 5 so angesteuert, daß das Bauelement 2 lagerichtig auf das Substrat 1 aufgesetzt wird. Eine Transporteinrichtung 10 dient zum Transport der Substrate 1 in den Bestückautomaten 7 hinein bis zur Bestückposition und aus dem Bestückautomaten 7 wieder heraus. Am Bestückkopf 5 ist darüber hinaus eine Substratkamera 17 angeordnet, mit der die Position der Substrate 1 ermittelt wird. Auch die Position des Substrates 1 geht in die Berechnung für die korrekte Lagepositionierung der Bauelemente 2 mit ein.

Der Bestückkopf 5 weist eine Speichereinrichtung 15 auf, die von der Steuereinheit 6 drahtlos oder drahtgebunden ausgelesen wird. Die Speichereinrichtung 15 kann dabei in den Bestückkopf 5 integriert sein, beispielsweise in Form eines berührungslos auslesbaren und beschreibbaren Speichers (Transponder, TAG) oder auch als separates Speichermedium (Diskette) ausgebildet sein, auf der die Daten eines bestimmten Bestückkopfes 5 abgespeichert sind und die von einem Diskettenlaufwerk der Steuereinrichtung 6 ausgelesen wird.

Auch die Zuführeinheiten 3 weisen eine solche Speichereinrichtung 16 auf, ebenso wie die Substratkamera 17 eine Speichereinrichtung 18 aufweist. Die Speichereinrichtungen 15,16,18 enthalten dabei jeweils charakteristische Daten des Bestückkopfes 5, der Zuführeinheit 3 bzw. der Substratkamera 17, so daß nach einem Austausch dieser auswechselbaren Komponenten diese Daten der Steuereinrichtung 6 zur Verfügung stehen. Die Steuereinrichtung 6 verwendet diese Daten dann zur Bestückung der Substrate 1 mit Bauelementen 2.

Die Ermittlung der Daten , die in der Speichereinrichtung 15 abgespeichert werden, ist exemplarisch in Figur 3 am Beispiel des Bestückkopfes 5 dargestellt. Dabei wird in diesem Beispiel ein sog. Revolverkopf mit insgesamt acht Saugpipetten 4, die entlang des Umfangs des Bestückkopfes 5 ausgebildet sind, dargestellt. Der Bestückkopf 5 kommt nach der Endmontage auf einen Prüfstand. Danach wird eine erste Saugpipette 4 über eine stationäre Kamera 22 auf den Prüfstand gefahren und dort im ausgefahrenen Zustand (entspricht der Position der Saugpipette beim Bestücken) vermessen. Sodann wird diese erste Saugpipette 4 zur Bauelemente-Kamera 21 des Bestückkopfes 5 getaktet und dort im eingefahrenen Zustand (entspricht der Position der Saugpipette beim Transport und bei der optischen Vermessung der Bauelemente während des Bestückprozesses) vermessen. Daraus ergibt sich in der Regel eine Differenz (sogenannter Schlag) zwischen der stationären Kamera 22 und der Bauelementekamera 21 (Mittenversatz), die in einer Kontrolleinrichtung 20 ausgewertet wird. Dieser Vorgang wird bei allen anderen sieben Saugpipetten 4 wiederholt und der Offset zur ersten Saugpipette in der Kontrolleinrichtung 20 ermittelt und anschließend in der Speichereinrichtung 15 gespeichert. Nach jedem Einbau des Bestückkopfes 5 in den Bestückautomaten 7 ist nur noch der Offset der ersten Saugpipette 4 mit herkömmlichen Mitteln zu ermitteln. Dieser Offset ist entweder bekannt, da der Bestückkopf 5 selbst über eine hochgenaue mechanische Schnittstelle, deren Bezugspunkt zum Bestückautomaten 7 bekannt ist, an den Bestückautomaten 7 angeschlossen wird. Oder der Offset dieser ersten Saugpipette 4 wird in dem Bestückautomaten 7 nach dem Einbau durch ortsfeste Sensoren (beispielsweise durch Bestückung eines Glassubstrats mit einem Glasbaustein) ermittelt. Die Daten aller übrigen Saugpipetten werden von der Speichereinrichtung 15 zur Steuereinrichtung 6 übertragen und dort verarbeitet. Der Bestückautomat 7 kann dann den Offset der übrigen sieben Saugpipetten, bezogen auf die erste Saugpipette 4, selbst errechnen. Anstelle der ersten Saugpipette 4 sind auch andere feste Bezugspunkte wählbar, deren Lage im Bestückautomat 7 bekannt oder leicht zu vermessen sind. Vor dem Einbau der auswechselbaren Komponenten 3,5,17 werden deren geometrische Daten dann in Bezug auf diesen festen Bezugspunkt ermittelt und in der Speichereinrichtung 15,16,18 abgespeichert.

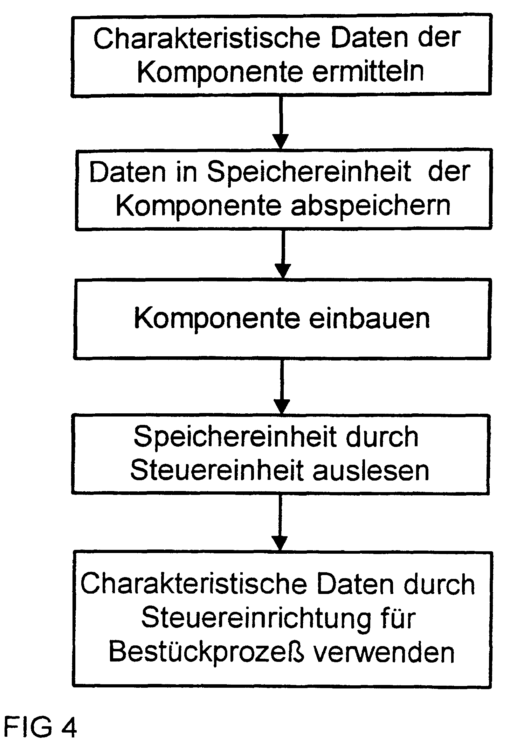

In Figur 4 ist anhand eines Strukturgramms der Verfahrensablauf noch einmal dargestellt. Dabei werden zunächst charakteristische Daten der auswechselbaren Komponente 3,5,17 ermittelt. Das können beispielsweise geometrische Daten der Komponenten 3,5,17 sein, aber auch Identifizierungsdaten oder ein dieser Komponente zugeordneter Funktionsumfang. Diese Daten werden dann in einer Speichereinrichtung 15,16,18, die der auswechselbaren Komponente 3,5,17 zugeordnet ist, abgespeichert. Nachdem die Komponente 3,5,17 eingebaut ist, wird der Inhalt der Speichereinrichtung 15,16,18 der Komponente 3,5,17 durch die Steuereinrichtung 6 des Bestückautomaten 7 ausgelesen. Die Steuereinrichtung 6 verwendet dann diese charakteristischen Daten für den Bestückprozeß des Bestückautomaten 7.

## Patentansprüche

1. Verfahren zum Betrieb eines Bestückautomaten (7) mit einer Steuereinrichtung (6), die die Bestückung von Substraten (1) mit Bauelementen (2) steuert, bei dem
- charakteristische, auf einen ortsfesten Bezugspunkt bezogene geometrische Daten einer auswechselbaren Komponente (3,5,17) des Bestückautomaten (7) vor dem Einbau in den Bestückautomaten (7) ermittelt und in einer der auswechselbaren Komponente (3,5,17) zugeordneten Speichereinrichtung (15,16,18) abgespeichert werden,
- nach dem Einbau der auswechselbaren Komponente (3,5,17) in den Bestückautomaten (7) zumindest ein Teil der charakteristischen Daten aus der Speichereinrichtung (15,16,18) in eine Steuereinrichtung (6) des Bestückautomaten (7) übertragen werden,
- die charakteristischen Daten von der Steuereinrichtung (6) im Betrieb des Bestückautomaten (7) mit berücksichtigt werden.

2. Verfahren zum Betrieb eines Bestückautomaten (7) nach Anspruch 1,
**dadurch gekennzeichnet,**
**daß** geometrische Daten der auswechselbaren Komponente
(3,5,17) vor dem Einbau gemessen werden und als charakteristische Daten abgespeichert werden.

3. Verfahren zum Betrieb eines Bestückautomaten (7) nach einem der Ansprüche 1 oder 2,
**dadurch gekennzeichnet,**
**daß** unterschiedlichen auswechselbaren Komponenten (3,5,17) unterschiedliche Identifizierungscodes zugeordnet werden und daß die der jeweiligen auswechselbaren Komponente (3,5,17) zugeordneten Identifizierungscodes als charakteristische Daten abgespeichert werden.

4. Verfahren zum Betrieb eines Bestückautomaten (7) nach einem der Ansprüche 1, 2 oder 3,
**dadurch gekennzeichnet,**
**daß** Komponentenklassen aus auswechselbaren Komponenten (3,5,17) gebildet werden, die ähnliche Funktionen ausführen, daß die Funktionen aller auswechselbaren Komponenten (3,5,17) zumindest einer der Komponentenklassen in einer Funktionsliste zusammengestellt werden,
**daß** die Funktionsliste zusammen mit der für die einzelen Funktionen zu erfolgenden Ansteuerung in der Steuereinrichtung (6) des Bestückautomaten (7) abgespeichert wird,
**daß** der auswechselbaren Komponente (3,5,17) die für diese Komponente (3,5,17) charakteristischen Funktionen zugeordnet werden, die diese Komponente (3,5,17) ausführen kann,
**daß** die charakteristischen Funktionen als charakteristische Daten in der Speichereinrichtung (15,16,18) abgespeichert werden.

5. Verfahren zum Betrieb eines Bestückautomaten (7) nach einem der Ansprüche 1 bis 4,
**dadurch gekennzeichnet,**
**daß** der Datenaustausch zwischen der Speichereinrichtung (15,16,18) der auswechselbaren Komponente (3,5,17) und der Steuereinrichtung (6) des Bestückautomaten (7) über elektrische Leitungen erfolgt.

6. Verfahren zum Betrieb eines Bestückautomaten (7) nach einem der Ansprüche 1 bis 4,
**dadurch gekennzeichnet,**
**daß** der Datenaustausch zwischen der Speichereinrichtung (15,16,18) der auswechselbaren Komponente (3,5,17) und der Steuereinrichtung (6) des Bestückautomaten (7) drahtlos erfolgt.

7. Verfahren zum Betrieb eines Bestückautomaten (7) nach Anspruch 2,
**dadurch gekennzeichnet,**
**daß** bei einem Bestückkopf (5) mit einer Vielzahl von Haltevorrichtungen (4) als auswechselbarer Komponente vor dem Einbau durch eine stationäre Kamera (22) die Position einer ersten Haltevorrichtung (4) in einer Position aufgenommen wird, die der. Position beim Bestücken auf dem Substrat (1) entspricht,
**daß** die Position der ersten Haltevorrichtung (4) in einer dem Bestückkopf (5) zugeordneten Bauelemente-Kamera (21) in einer zweiten Position aufgenommen wird, die der Position der Haltevorrichtung (4) beim Transport und beim optischen Vermessen der Bauelemente (2) entspricht,
**daß** die beiden aufgenommenen Positionen in einer den beiden Kameras (21, 22) nachgeschalteten Meßeinrichtung (20) verglichen werden und dabei ein Versatz:ermittelt wird, der in der Speichereinrichtung (15) abgespeichert wird,
**daß** die Positionen der anderen Haltevorrichtungen (4) ebenso von der stationären Kamera (22) und der Bauelemente-Kamera (21) aufgenommen werden, in der Meßeinrichtung (20) verglichen und die ermittelte Versätze in der Speichereinrichtung (15) abgespeichert werden,
**daß** zusätzlich der relative Versatz der anderen Haltevorrichtungen (4) relativ zur.ersten Haltevorrichtung (4) in der Meßeinrichtung (20) ermittelt und in der Speichereinrichtung (15) abgespeichert wird,
**daß** nach dem Einbau des Bestückkopfes (5) die relative Position der ersten Haltevorrichtung (4) zum Bestückautomaten (7) ermittelt wird und die relativen Versätze der anderen Haltevorrichtungen (4) von der Speichereinrichtung (15) an die Steuereinrichtung (6) übermittelt werden.

8. Bestückautomat (7) mit einer Steuereinrichtung (6) zum Betrieb des Bestückautomaten und mit einem Bestückkopf (5) zum Aufnehmen von Bauelementen (2) und nachfolgendem Absetzen der Bauelemente (2) auf einem Substrat (1)
**dadurch gekennzeichnet,**
**daß** die Steuereinrichtung (6) eine Auslgpeeinriihtung aufweist, mit der charakteristische, auf einen ortsfesten Bezugspunkt bezogene geometrische Daten einer auswechselbaren Komponente (3, 5, 17) des Bestückautomaten (7) aus einer mit der auswechselbaren Komponente (3,5,17) gekoppelten Speichereinrichtung (15,16,18) auslesbar sind und
**daß** die Steuereinrichtung (6) so ausgebildet ist, daß diese die ausgelesen charakteristischen Daten abspeichert und für den Bestückprozeß verwendet.

9. Auswechselbare Komponente (3,5,17) für einen Bestückautomaten (7) gekoppelt mit einer Speichereinrichtung (15,16,18), die charakteristische auf einen ortsfesten Bezugspunkt bezogene geometrische Daten der auswechselbaren Komponente (3,5,17) enthält.

10. Auswechselbare Komponente (3,5,17) für einen Bestückautomaten. (7) nach Anspruch 9,
**dadurch gekennzeichnet,**
**daß** die Speichereinrichtung (15,16,18) als berührungslos beschreibbarer und auslesbarer Speicher ausgebildet ist, der direkt mit der auswechselbaren Komponente (3,5,17) verbunden ist.

11. Auswechselbare Komponente (3,5,17) für einen Bestückautomaten (7) nach einem der Ansprüche 9 oder 10,
**dadurch gekennzeichnet,**
**daß** die auswechselbare Komponente als Bestückkopf (5) ausgebildet ist.

12. Auswechselbare Komponente (3,5,17) für einen Bestückautomaten (7) nach einem der Ansprüche 9 oder 10,
**dadurch gekennzeichnet,**
**daß** die auswechselbare Komponente als Zuführeinheit (3) ausgebildet ist.

13. Auswechselbare Komponente (3,5,17) für einen Bestückautomaten (7) nach einem der Ansprüche 9 oder 10,
**dadurch gekennzeichnet,**
**daß** die auswechselbare Komponente als Sensor (17) ausgebildet ist.

14. System aus einem Bestückautomaten (7) und einer auswechselbaren Komponente (3,5,17) des Bestückautomaten (7), wobei
- der Bestückautomat (7) eine Steuereinrichtung (6) aufweist,
- mit der auswechselbaren Komponente (3 , 5, 17) eine Speichereinrichtung (15,16,18) gekoppelt ist, die charakteristische, auf einen ortsfesten Bezugspunkt bezogene geometrische Daten der Komponente (15,16,18) enthält,
- die Steuereinrichtung (6) so ausgebildet ist, daß diese die charakteristischen Daten aus der Speichereinrichtung (15,16,18) ausliest und diese Daten für den Bestückprözeß mit verwendet.

## Claims

1. Method for operating a pick-and-place machine (7) with a control device (6), which controls the picking and placing of components (2) onto substrates (1), in which method
- characteristic, geometrical data, based on a fixed reference point, of an exchangeable component (3, 5, 17) of the pick-and-place machine (7) are determined before it is mounted in the pick-and-place machine (7) and are stored in a memory device (15, 16, 18) assigned to the exchangeable component (3, 5, 17),
- after the exchangeable component (3, 5, 17) has been mounted in the pick-and-place machine (7), at least some of the characteristic data are transferred from the memory device (15, 16, 18) into a control device (6) of the pick-and-place machine (7),
- the characteristic data are taken into account by the control device (6) during the operation of the pick-and-place machine (7).

2. Method for operating a pick-and-place machine (7) according to Claim 1, **characterized in that** geometrical data of the exchangeable component (3, 5, 17) are measured before it is mounted and are stored as characteristic data.

3. Method for operating a pick-and-place machine (7) according to one of Claims 1 or 2, **characterized in that** different exchangeable components (3, 5, 17) are assigned different identification codes and **in that** the identification codes assigned to the respective exchangeable component (3, 5, 17) are stored as characteristic data.

4. Method for operating a pick-and-place machine (7) according to one of Claims 1, 2 or 3, **characterized in that** component classes of exchangeable components (3, 5, 17) which perform similar functions are formed, **in that** the functions of all the exchangeable components (3, 5, 17) of at least one of the component classes are compiled in a function list, **in that** the function list is stored, together with the activation to be carried out for the individual functions, in the control device (6) of the pick-and-place machine (7), **in that** the exchangeable component (3, 5, 17) is assigned the functions characteristic of this component, which this component (3, 5, 17) can perform, **in that** the characteristic functions are stored as characteristic data in the memory device (15, 16, 18).

5. Method for operating a pick-and-place machine (7) according to one of Claims 1 to 4, **characterized in that** the data exchange between the memory device (15, 16, 18) of the exchangeable component (3, 5, 17) and the control device (6) of the pick-and-place machine (7) takes place over electrical lines.

6. Method for operating a pick-and-place machine (7) according to one of Claims 1 to 4, **characterized in that** the data exchange between the memory device (15, 16, 18) of the exchangeable component (3, 5, 17) and the control device (6) of the pick-and-place machine (7) takes place wirelessly.

7. Method for operating a pick-and-place machine (7) according to Claim 2, **characterized in that**, in the case of a pick-and-place head (5) with a multiplicity of holding devices (4) as an exchangeable component, before it is mounted the position of a first holding device (4) is recorded by a stationary camera (22) in a position which corresponds to the position during placement on the substrate (1), **in that** the position of the first holding device (4) is recorded, in a component camera (21) assigned to the pick-and-place head (5), in a second position, which corresponds to the position of the holding device (4) during transporting and during the optical measuring of the components (2), **in that** the two recorded positions are compared in a measuring device (20) downstream of the two cameras (21, 22) and this comparison is used to determine an offset, which is stored in the memory device (15), **in that** the positions of the other holding devices (4) are similarly recorded by the stationary camera (22) and the component camera (21), compared in the measuring device (20) and the predetermined offsets are stored in the memory device (15), **in that**, in addition, the relative offset of the other holding devices (4) in relation to the first holding device (4) is determined in the measuring device (20) and stored in the memory device (15), **in that**, after the pick-and-place head (5) has been mounted, the relative position of the first holding device (4) with respect to the pick-and-place machine (7) is determined and the relative offsets of the other holding devices (4) are transferred from the memory device (15) to the control device (6).

8. Pick-and-place machine (7) with a control device (6) for operating the pick-and-place machine and with a pick-and-place head (5) for receiving components (2) and subsequently depositing the components (2) on a substrate (1), **characterized in that** the control device (6) has a reading-out device, with which characteristic, geometrical data, based on a fixed reference point, of an exchangeable component (3, 5, 17) of the pick-and-place machine (7) can be read out from a memory device (15, 16, 18) coupled to the exchangeable component (3, 15, 17), and **in that** the control device (6) is designed in such a way that it stores the read-out characteristic data and uses them for the picking-and-placing process.

9. Exchangeable component (3, 5, 17) for a pick-and-place machine (7) coupled to a memory device (15, 16, 18) which contains characteristic, geometrical data, based on a fixed reference point, of the exchangeable component (3, 5, 17).

10. Exchangeable component (3, 5, 17) for a pick-and-place machine (7) according to Claim 9, **characterized in that** the memory device (15, 16, 18) is designed as a contactlessly writable and readable memory, which is connected directly to the exchangeable component (3, 5, 17).

11. Exchangeable component (3, 5, 17) for a pick-and-place machine (7) according to one of Claims 9 or 10, **characterized in that** the exchangeable component is designed as a pick-and-place head (5).

12. Exchangeable component (3, 5, 17) for a pick-and-place machine (7) according to one of Claims 9 or 10, **characterized in that** the exchangeable component is designed as a feeding unit (3).

13. Exchangeable component (3, 5, 17) for a pick-and-place machine (7) according to one of Claims 9 or 10, **characterized in that** the exchangeable component is designed as a sensor (17).

14. System comprising a pick-and-place machine (7) and an exchangeable component (3, 5, 17) of the pick-and-place machine (7), in which system
- the pick-and-place machine (7) has a control device (6),
- coupled to the exchangeable component (3, 5, 17) is a memory device (15, 16, 18) which contains characteristic, geometrical data, based on a fixed reference point, of the component (15, 16, 18) and
- the control device (6) is designed in such a way that it reads out the characteristic data from the memory device (15, 16, 18) and uses these data for the picking-and-placing process.

## Revendications

1. Procédé pour le fonctionnement d'un automate d'équipement (7) avec un appareil de commande (6), qui commande l'équipement de substrats (1) avec des composants (2), dans lequel
- des données caractéristiques, rapportées à un point de référence fixe d'un composant (3, 5, 17) interchangeable et géométriques de l'automate d'équipement (7) sont déterminées avant le montage dans l'automate d'équipement (7) et sont mémorisées dans un appareil de stockage (15, 16, 18) attribué au composant (3, 5, 17) interchangeable,
- au moins une partie des données caractéristiques provenant de l'appareil de stockage (15, 16, 18) est transmise dans un appareil de commande (6) de l'automate d'équipement (7) après le montage du composant (3, 5, 17) interchangeable dans l'automate d'équipement (7),
- les données caractéristiques sont prises en compte également par l'appareil de commande (6) pendant le fonctionnement de l'automate d'équipement (7).

2. Procédé pour le fonctionnement d'un automate d'équipement (7) selon la revendication 1,
**caractérisé en ce que** des données géométriques du composant (3, 5, 17) interchangeable sont mesurées avant le montage et mémorisées sous la forme de données caractéristiques.

3. Procédé pour le fonctionnement d'un automate d'équipement (7) selon l'une quelconque des revendications 1 ou 2,
**caractérisé en ce que** différents codes d'identification sont attribués à différents composants (3, 5, 17) interchangeables et
**en ce que** les codes d'identification attribués au composant (3, 5, 17) interchangeable respectif sont stockés sous la forme de données caractéristiques.

4. Procédé pour le fonctionnement d'un automate d'équipement (7) selon l'une quelconque des revendications 1, 2 ou 3,
**caractérisé**
**en ce que** des classes de composants constituées de composants (3, 5, 17) interchangeables sont formées, qui exécutent des fonctions similaires,
**en ce que** les fonctions de tous les composants (3, 5, 17) interchangeables d'au moins l'une des classes de composants sont regroupées dans une liste de fonctions,
**en ce que** la liste de fonctions est mémorisée en même temps que l'amorçage à effectuer pour les différentes fonctions de l'appareil de commande (6) de l'automate d'équipement (7),
**en ce que** les fonctions caractéristiques de ce composant (3, 5, 17), que ce composant (3, 5, 17) peut exécuter, sont attribuées au composant (3, 5, 17) interchangeable
**en ce que** les fonctions caractéristiques sont mémorisées comme des données caractéristiques dans l'appareil de stockage (15, 16, 18).

5. Procédé pour le fonctionnement d'un automate d'équipement (7) selon l'une quelconque des revendications 1 à 4,
**caractérisé en ce que** l'échange de données entre l'appareil de stockage (15, 16, 18) du composant (3, 5, 17) interchangeable et l'appareil de commande (6) de l'automate d'équipement (7) s'effectue au moyen de lignes électriques.

6. Procédé pour le fonctionnement d'un automate d'équipement (7) selon l'une quelconque des revendications 1 à 4,
**caractérisé en ce que** l'échange de données entre l'appareil de stockage (15, 16, 18) du composant (3, 5, 17) interchangeable et l'appareil de commande (6) de l'automate d'équipement (7) s'effectue sans fil.

7. Procédé pour le fonctionnement d'un automate d'équipement (7) selon la revendication 2,
**caractérisé en ce que**, avec une tête d'équipement (5) comprenant une pluralité de dispositifs de retenue (4) en tant que composant interchangeable, la position d'un premier dispositif de retenue (4) est enregistrée avant le montage par une caméra (22) fixe dans une position qui correspond à la position lors de l'équipement sur le substrat (1),
**en ce que** la position du premier dispositif de retenue (4) est enregistrée dans une caméra pour composants (21) attribuée à la tête d'équipement (5) dans une seconde position qui correspond à la position du dispositif de retenue (4) lors du transport et lors du mesurage optique des composants (2),
**en ce que** les deux positions enregistrées sont comparées dans un appareil de mesure (20) placé en aval des deux caméras (21, 22) et un déport, qui est mémorisé dans l'appareil de stockage (15), est alors déterminé,
**en ce que** les positions des autres dispositifs de retenue (4) sont enregistrées également par la caméra (22) fixe et la caméra pour composants (21), comparées dans l'appareil de mesure (20) et les déports déterminés sont mémorisés dans l'appareil de stockage (15),
**en ce qu'**en supplément le déport relatif des autres dispositifs de retenue (4) est déterminé par rapport au premier dispositif de retenue (4) dans l'appareil de mesure (20) et mémorisé dans l'appareil de stockage (15),
**en ce qu'**après le montage de la tête d'équipement (5), la position relative du premier dispositif de retenue (4) par rapport à l'automate d'équipement (7) est déterminée et les déports relatifs des autres dispositifs de retenue (4) sont transmis de l'appareil de stockage (15) à l'appareil de commande (6).

8. Automate d'équipement (7) comprenant un appareil de commande (6) pour le fonctionnement de l'automate d'équipement et une tête d'équipement (5) pour la réception des composants (2) et la dépose consécutive des composants (2) sur un substrat (1)
**caractérisé en ce que** l'appareil de commande (6) présente un appareil de lecture qui permet de lire des données caractéristiques, rapportées à un point de référence fixe et géométriques d'un composant (3, 5, 17) interchangeable de l'automate d'équipement (7) provenant d'un appareil de stockage (15, 16, 18) couplé avec le composant (3, 5, 17) interchangeable et
**en ce que** l'appareil de commande (6) est conçu de telle sorte qu'il stocke les données caractéristiques lues et les utilise pour le processus d'équipement.

9. Composant (3, 5, 17) interchangeable pour un automate d'équipement (7) couplé avec un appareil de stockage (15, 16, 18) qui contient des données caractéristiques, rapportées à un point de référence fixe et géométriques du composant (3, 5, 17) interchangeable.

10. Composant (3, 5, 17) interchangeable pour un automate d'équipement (7) selon la revendication 9,
**caractérisé en ce que** l'appareil de stockage (15, 16, 18) est conçu comme une mémoire pouvant être inscrite et lue sans contact, qui est reliée directement au composant (3, 5, 17) interchangeable.

11. Composant (3, 5, 17) interchangeable pour un automate d'équipement (7) selon l'une quelconque des revendications 9 ou 10, et
**caractérisé en ce que** le composant interchangeable est conçu comme une tête d'équipement (5).

12. Composant (3, 5, 17) interchangeable pour un automate d'équipement (7) selon l'une quelconque des revendications 9 ou 10,
**caractérisé en ce que** le composant interchangeable est conçu comme une unité d'alimentation (3).

13. Composant (3, 5, 17) interchangeable pour un automate d'équipement (7) selon l'une quelconque des revendications 9 ou 10,
**caractérisé en ce que** le composant interchangeable est conçu comme un capteur (17).

14. Système comprenant un automate d'équipement (7) et un composant (3, 5, 17) interchangeable de l'automate d'équipement (7),
- l'automate d'équipement (7) présentant un appareil de commande (6),
- un appareil de stockage (15, 16, 18), qui contient des données caractéristiques, rapportées à un point de référence fixe et géométriques du composant (15, 16, 18), étant couplé avec le composant (3, 5, 17) interchangeable,
- l'appareil de commande (6) étant conçu de telle sorte qu'il lit les données caractéristiques extraites de l'appareil de stockage (15, 16, 18) et les utilise également pour le processus d'équipement.
